(19) Europäisches Patentamt
European Patent Office
Office européen des brevets

(11) **EP 2 557 426 B1**

(12) **EUROPÄISCHE PATENTSCHRIFT**

(45) Veröffentlichungstag und Bekanntmachung des Hinweises auf die Patenterteilung:
**28.01.2015 Patentblatt 2015/05**

(51) Int Cl.:
**G01R 19/25** *(2006.01)*          **G01R 31/42** *(2006.01)*
G05B 21/02 *(2006.01)*

(21) Anmeldenummer: **12179569.4**

(22) Anmeldetag: **07.08.2012**

(54) **Verfahren zum Messen eines mittels eines Frequenzumrichters erzeugten analogen Signals**

Method of measuring an analog signal generated by a frequency inverter

Procédé de mesure d'un signal analogue généré par un onduleur

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.08.2011 DE 102011080587**

(43) Veröffentlichungstag der Anmeldung:
**13.02.2013 Patentblatt 2013/07**

(73) Patentinhaber: **Lenze Automation GmbH**
**31855 Aerzen (DE)**

(72) Erfinder:
• **Düsterberg, Dirk**
**31860 Emmerthal (DE)**
• **Klaus, Uwe**
**38321 Denkte (DE)**

(74) Vertreter: **Patentanwälte**
**Ruff, Wilhelm, Beier, Dauster & Partner**
**Kronenstrasse 30**
**70174 Stuttgart (DE)**

(56) Entgegenhaltungen:
**EP-A1- 0 454 946          EP-A1- 1 333 291**
**WO-A1-03/032689          WO-A1-2009/007407**

**Beschreibung**

Die Erfindung betrifft ein Verfahren zum Messen eines mittels eines Frequenzumrichters erzeugten analogen Signals und einen Frequenzumrichter.

Frequenzumrichter erzeugen zur Ansteuerung von Elektromotoren typisch pulsweitenmodulierte Signale, beispielsweise in Form einer (Phasen-)Spannung, wobei die Phasenspannung wiederum einen Phasenstrom bewirkt. Bei Frequenzumrichtern, die den Phasenstrom im Kontext einer Regelung zurückführen, ist die Qualität der Signalmessung bzw. Signalrückführung von hoher Bedeutung.

Die zu messenden Signale werden hierzu üblicherweise mittels geeigneter Sensoren aufgenommen, analog gefiltert und anschließend mittels herkömmlicher Analog-Digital-Wandler abgetastet und digitalisiert.

Der im Allgemeinen sägezahnförmige Phasenstrom als eines der relevanten Signale wird üblicherweise synchron in der Mitte einer jeweiligen Periode der Pulsweitenmodulation abgetastet. Bei nicht exakt mittiger Abtastung kann jedoch ein Offset-Messfehler verursacht werden.

Durch Mittelwertbildung über eine Periodendauer der Pulsweitenmodulation lassen sich die oben genannten Störeffekte reduzieren. Zur Mittelwertbildung wird herkömmlich eine Mehrzahl von digitalen Messwerten über eine Periodendauer der Pulsweitenmodulation gewonnen und anschließend ein Mittelwert über die gewonnenen Messwerte berechnet.

Ein Verfahren, bei dem eine solche Mittelwertbildung durchgeführt wird, ist in der DE 10 2007 032 484 A1 beschrieben. Hierbei wird im Kontext einer mehrkanaligen Rückführung eine zusätzliche Rückführgröße für eine Regelung durch Mitteln der Regelgröße über einen gegebenen Zeitraum ermittelt und mit einer Führungsgröße verglichen.

Die Mittelwertbildung zur Erzeugung der Rückführgröße verschlechtert jedoch die dynamischen Eigenschaften der Regelung, da der Mittelwert prinzipbedingt nur verzögert zur Verfügung steht. Die DE 10 2007 032 484 A1 trägt diesem Problem durch die mehrkanalige Rückführung Rechnung, bei der eine der Rückführgrößen eine im Vergleich zum Mittelwert geringere Verzögerung aufweist.

Die EP 0 454 946 A1 zeigt ein Verfahren zur Ermittlung von Schätzwerten der Momentanwerte von Parametern mindestens eines sinusförmigen Signals mit konstanter und vorbekannter Frequenz.

Die EP 1 333 291 A1 zeigt ein Verfahren und eine Vorrichtung zum Detektieren eines Stroms.

Die WO 03/032689 A1 zeigt eine pulsweitenmodulationsbasierte Steuerung eines LED-Felds.

Der Erfindung liegt die Aufgabe zugrunde, ein Verfahren zum Messen mindestens eines mittels eines Frequenzumrichters auf Basis einer Pulsweitenmodulation erzeugten bzw. bewirkten analogen Signals und einen Frequenzumrichter zur Verfügung zu stellen, die eine möglichst störsichere Messwerterfassung unter Beibehaltung der Dynamik der Messgröße ermöglichen.

Die Erfindung löst diese Aufgabe durch ein Verfahren nach Anspruch 1 und einen Frequenzumrichter nach Anspruch 3.

Eine bevorzugte Ausführungsform ist Gegenstand des Unteranspruchs 2, dessen Wortlaut hiermit durch Bezugnahme zum Inhalt der Beschreibung gemacht wird.

Das Verfahren zum Messen mindestens eines analogen Signals, beispielsweise eines Phasenstroms, welches bzw. welcher mittels eines Frequenzumrichters auf Basis einer Pulsweitenmodulation erzeugt wird, beispielsweise auf Basis einer Pulsweitenmodulation einer Phasenspannung erzeugt wird, weist die Schritte auf: Abtasten des analogen Signals zum Erzeugen einer Folge von, insbesondere zeit- und amplitudendiskret, digitalisierten Abtastwerten $i(n)$, mit $i = 0, ..., n$, wobei pro Periode der Pulsweitenmodulation genau ein Abtastwert $i(n)$ erzeugt wird, Bilden eines Signalmittelwerts $i\_mittel(n-1)$ des analogen Signals über die dem aktuellen Abtastwert $i(n)$ vorangegangene Periode, insbesondere in digitaler Darstellung, und Berechnen eines aktuellen Messwerts $mw$ anhand der Gleichung $mw = i(n) - i(n-1) + i\_mittel(n-1)$.

Unter einer digitalen Darstellung eines Signals bzw. einem Digitalsignal wird eine Folge von zeit- und amplitudendiskret digitalisierten Abtastwerten verstanden, die einerseits einen abgegrenzten und gestuften Wertvorrat aufweisen und zudem in der zeitlichen Abfolge nur zu bestimmten periodischen Zeitpunkten definiert sind bzw. eine Veränderung im Abtastwert zeigen. Das Signal in digitaler Darstellung wird aus einem zugehörigen analogen Signal, welches den zeitlich kontinuierlichen Verlauf einer physikalischen Größe beschreibt, durch Quantisierung und Abtastung, welche zu definierten Zeitpunkten erfolgt, gebildet. Durch eine entsprechende Codierung kann ein Digitalsignal in eine binäre Darstellung übergeführt werden. Im Übrigen sei auch auf die umfangreiche Fachliteratur verwiesen.

Das Bilden des Mittelwerts $i\_mittel(n-1)$ umfasst die Schritte: Abtasten des analogen Signals zum Erzeugen einer Mehrzahl M von, insbesondere zeit- und amplitudendiskret, digitalisierten Zwischenabtastwerten $z(1)$ bis $z(M)$ für die vorangegangene Periode und Bilden eines Zwischenabtastwertemittelwerts aus den erzeugten Zwischenabtastwerten als Signalmittelwert.

Das Abtasten des analogen Signals zum Erzeugen der Folge von digitalisierten Abtastwerten $i(n)$ wird in Periodenmitte durchgeführt.

In einer Weiterbildung dient das gemessene Signal als Rückführgröße für eine Regelung, insbesondere des analogen Signals.

Der Frequenzumrichter ist zur Durchführung des oben genannten Verfahrens ausgebildet. Der Frequenzumrichter umfasst Abtastmittel bzw. einen Analog-Digital-Wandler zum Abtasten des analogen Signals zum Erzeugen einer Folge von, insbesondere zeit- und amplitudendiskret, digitalisierten Abtastwerten i(n), mit i = 0, ..., n, wobei pro Periode der Pulsweitenmodulation genau ein Abtastwert i(n) erzeugt wird, Mittelwerterzeugungsmittel, beispielsweise in Form eines Field Programmable Gate Array (FPGA), zum Bilden eines Signalmittelwerts i_mittel(n-1) des analogen Signals über die dem aktuellen Abtastwert i(n) vorangegangene Periode in digitaler Darstellung und Berechnungsmittel, beispielsweise in Form eines Mikroprozessors, zum Berechnen eines aktuellen Messwerts mw anhand der Gleichung mw = i(n) - i(n-1) + i_mittel(n-1).

Die Erfindung wird nachfolgend unter Bezugnahme auf die Zeichnung beschrieben, die bevorzugte Ausführungsformen der Erfindung darstellt. Hierbei zeigt schematisch:

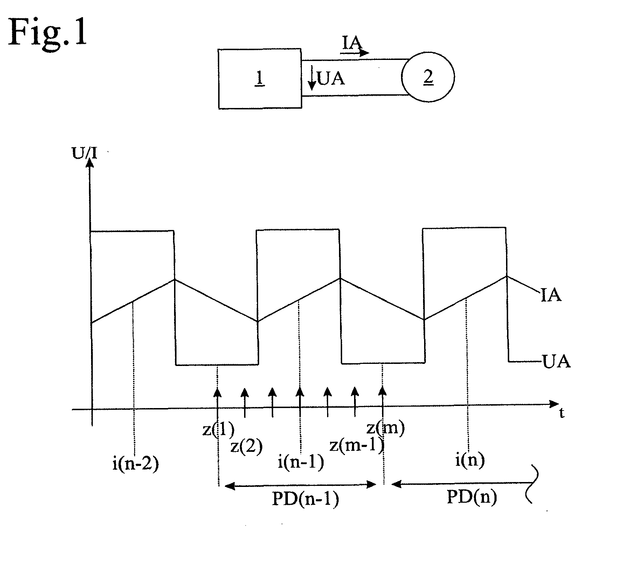

Fig. 1     mittels eines Frequenzumrichters erzeugte bzw. bewirkte analoge Signale in Form einer Phasenspannung und eines Phasenstroms.

Fig. 1 zeigt herkömmlich mittels eines Frequenzumrichters 1 auf Basis einer Pulsweitenmodulation erzeugte bzw. bewirkte analoge Signale in Form einer im Wesentlichen rechteckförmigen, pulsweitenmodulierten Phasenspannung UA mit einem veränderlichen Tastverhältnis und eines zugehörigen, sich einstellenden, sagezahnförmigen Phasenstroms IA, wie sie typisch bei der pulsweitenmodulationsbasierten Ansteuerung eines Elektromotors 2 durch den Frequenzumrichter 1 bewirkt werden.

Zum Messen des Phasenstroms IA als Rückführungsgröße im Zuge einer Regelung wird der Phasenstrom IA zunächst zum Erzeugen einer Folge von zeit- und amplitudendiskret digitalisierten Abtastwerten i(n), mit i = 0, ..., n, in der Mitte einer jeweiligen Periode PD der Pulsweitenmodulation abgetastet, wobei pro Periode PD genau ein Abtastwert i(n) erzeugt wird.

Weiter wird ein Signalmittelwert i_mittel(n-1) des Phasenstroms IA über die dem aktuellen Abtastwert i(n) vorangegangene Periode PD(n-1) in digitaler Darstellung ermittelt, indem für die vorangegangene Periode PD(n-1) der Strom IA zum Erzeugen einer Mehrzahl M von zeit- und amplitudendiskret digitalisierten Zwischenabtastwerten z(1) bis z(M) abgetastet wird, wobei eine Abtastrate zur Erzeugung der Zwischenabtastwerte z(1) bis z(M) M-fach größer ist als eine Abtastrate der Abtastwerte i(n). Die Zwischenabtastwerte sind über die gesamte vorangegangene Periode PD(n-1) zeitlich äquidistant verteilt. M kann beispielsweise gleich 16 sein.

Der Signalmittelwert i_mittel(n-1) wird nun als Mittelwert der Zwischenabtastwerte z berechnet, d.h. es gilt:

$$i\_mittel(n-1) = \frac{1}{M} \sum_{s=1}^{s=M} z(s)$$

Der aktuelle Messwert mw wird anhand folgender Gleichung berechnet:

$$mw = i(n) - i(n-1) + i\_mittel(n-1).$$

Die oben genannten Schritte werden fortlaufend für eine jeweilige Periode der Pulsweitenmodulation wiederholt.

Das gemessene Signal bzw. der aktuelle Messwert mw dient als Rückführgröße für eine Regelung des Stroms IA.

Erfindungsgemäß werden zu definierten Zeitpunkten, die idealerweise in oberschwingungsfreien Zeitpunkten der Pulsweitenmodulation liegen, zwei Werte ermittelt, nämlich ein Momentanwert und ein zu diesem Zeitpunkt korrespondierender gemittelter Wert über eine PWM-Periode.

Bei gleichen gemessenen Momentanwerten i(n) und i(n-1) bleibt i_mittel(n-1) als gemittelter, wenig störungsbehafteter Wert übrig. Sofern sich i(n) und i(n-1) unterscheiden, ist der errechnete Wert um den errechneten Fehler der letzten Messung von der Momentanmessung verschieden, ansonsten aber ohne Verzögerungszeit sofort verfügbar.

Die gezeigten Ausführungsformen stellen eine Kombination von geringer Verzögerungszeit und exakter Integration des Messwertes über eine Periode dar. Dies ermöglicht eine störsichere Messung bei gleichzeitig hoher Dynamik des Messwerts.

Der Frequenzumrichter 1 weist Mittel auf, die zur Durchführung des beschriebenen Verfahrens ausgebildet sind, beispielsweise Analog-Digital-Wandler, ein FPGA und/oder einen Mikroprozessor bzw. Signalprozessor.

**Patentansprüche**

1.   Verfahren zum Messen eines mittels eines Frequenzumrichters (1) auf Basis einer Pulsweitenmodulation erzeugten analogen Signals (IA), mit den Schritten

    - Abtasten des analogen Signals zum Erzeugen einer Folge von, insbesondere zeit- und amplitudendiskret, digitalisierten Abtastwerten i(n), mit i = 0, ... , n, wobei das Abtasten des analogen Signals zum Erzeugen der Folge von digitalisierten Abtastwerten i(n) in Periodenmitte durchgeführt wird,

**gekennzeichnet durch** die Schritte

- Bilden eines Signalmittelwerts i_mittel(n-1) des analogen Signals über die dem aktuellen Abtastwert i(n) vorangegangene Periode, wobei das Bilden des Signalmittelwerts i_mittel(n-1) die Schritte umfasst:

- Abtasten des analogen Signals zum Erzeugen einer Mehrzahl M von, insbesondere zeit- und amplitudendiskret, digitalisierten Zwischenabtastwerten z(1) bis z(M) für die vorangegangene Periode und
- Bilden eines Zwischenabtastwertemittelwerts aus den erzeugten Zwischenabtastwerten als Signalmittelwert, und

- Berechnen eines aktuellen Messwerts mw anhand der Gleichung mw = i(n) - i(n-1) + i_mittel(n-1),

- wobei pro Periode (PD) der Pulsweitenmodulation genau ein Abtastwert i(n) erzeugt wird.

**2.** Verfahren nach Anspruch 1, **dadurch gekennzeichnet, dass**

- das gemessene Signal als Rückführgröße für eine Regelung dient.

**3.** Frequenzumrichter (1), **dadurch gekennzeichnet, dass** er zur Durchführung des Verfahrens nach Anspruch 1 oder 2 ausgebildet ist und aufweist:

- Abtastmittel zum Abtasten des analogen Signals zum Erzeugen einer Folge von, insbesondere zeit- und amplitudendiskret, digitalisierten Abtastwerten i(n), mit i = 0, ..., n, wobei pro Periode (PD) der Pulsweitenmodulation genau ein Abtastwert i(n) erzeugt wird und das Abtasten des analogen Signals zum Erzeugen der Folge von digitalisierten Abtastwerten i(n) in Periodenmitte durchgeführt wird,
- Mittelwerterzeugungsmittel zum Bilden eines Signalmittelwerts i_mittel(n-1) des analogen Signals über die dem aktuellen Abtastwert i(n) vorangegangene Periode in digitaler Darstellung mittels Abtasten des analogen Signals zum Erzeugen einer Mehrzahl M von, insbesondere zeit- und amplitudendiskret, digitalisierten Zwischenabtastwerten z(1) bis z(M) für die vorangegangene Periode und Bilden eines Zwischenabtastwertemittelwerts aus den erzeugten Zwischenabtastwerten als Signalmittelwert, und

- Berechnungsmittel zum Berechnen eines aktuellen Messwerts mw anhand der Gleichung mw = i(n) - i(n-1) + i_mittel(n-1).

## Claims

**1.** Method for measuring an analog signal (IA) generated by a frequency converter (1) based on pulse-width modulation, comprising the steps

- sampling of the analog signal for generating a sequence of, in particular discrete time and discrete amplitude, digitalized sampled values i(n), wherein i = 0, ..., n, the sampling of the analog signal for generating the sequence of digitalized sampled values i(n) being performed in mid-period,

**characterized by** the steps

- obtaining a signal average value i_mittel(n-1) of the analog signal over the period preceding the current sampled value i(n), wherein obtaining the signal average value i_mittel(n-1) comprises the steps:

- sampling the analog signal for generating a plurality M of, in particular discrete time and discrete amplitude, digitalized intermediate sampled values z(1) to z(M) for the preceding period, and
- obtaining an average intermediate sampled value from the generated intermediate sampled values as a signal average value, and

- calculating a current measured value mw based on the equation

$$mw = i(n) - i(n-1) + i\_mittel(n-1),$$

- wherein exactly one sampled value i(n) is generated per period (PD) of the pulse-width modulation.

**2.** Method according to claim 1, **characterized in that**

- the measured signal is a feedback variable for a feedback control.

**3.** Frequency converter (1), **characterized in that** it is configured for implementing the method according to claim 1 or 2 and comprises:

- sampling means for sampling the analog signal for generating a sequence of, in particular discrete time and discrete amplitude, digitalized sampled values i(n), with i = 0, ..., n, wherein exactly one sampled value i(n) is generated per period (PD) of the pulse-width modulation and the sampling of the analog signal for generating the sequence of digitalized sampled values i(n) is performed in mid-period,
- average value generator means for obtaining a signal average value i_mittel(n-1) of the analog signal over the period preceding the current sampled value i(n) in digital representation using sampling of the analog signal for generating a plurality M of, in particular discrete time and discrete amplitude, digitalized intermediate sampled values z(1) to z(M) for the preceding period and obtaining an average intermediate sampled value from the generated intermediate sampled values as a signal average value, and
- calculator means for calculating a current measured value mw based on the equation mw = i(n) - i(n-1) + i_mittel(n-1).

## Revendications

1. Procédé pour mesurer un signal analogique (IA) généré sur la base d'une modulation des impulsions en largeur à l'aide d'un convertisseur de fréquence (1), avec l'étape

   - d'exploration du signal analogique pour la génération d'une séquence de valeurs d'exploration i(n) numérisées, en particulier discrètes en temps et en amplitude, avec i = 0,..., n, l'exploration du signal analogique pour la génération de la séquence de valeurs d'exploration i(n) numérisées étant mise en oeuvre en milieu de période,

   **caractérisé par** les étapes suivantes

   - formation d'une valeur moyenne de signal i_mittel(n-1) du signal analogique sur la période ayant précédé la valeur d'exploration i(n) actuelle, la formation de la valeur moyenne de signal i_mittel(n-1) comprenant les étapes suivantes :

      - exploration du signal analogique pour la génération d'une pluralité M de valeurs d'exploration intermédiaires z(1) à z(M) numérisées, en particulier discrètes en temps et en amplitude, pour la période précédente, et
      - formation d'une valeur moyenne des valeurs d'exploration intermédiaires à partir des valeurs d'exploration intermédiaires générées en tant que valeur moyenne de signal, et

   - calcul d'une valeur de mesure actuelle mw à l'aide de l'équation mw = i(n) - i(n-1) + i_mittel(n-1),

      - exactement une valeur d'exploration i(n) étant générée par période (PD) de la modulation des impulsions en largeur.

2. Procédé selon la revendication 1, **caractérisé en ce que**

   - le signal mesuré sert de grandeur de retour pour un réglage.

3. Convertisseur de fréquence (1), **caractérisé en ce qu'**il est réalisé pour la mise en oeuvre du procédé selon la revendication 1 ou la revendication 2 et présente :

   - des moyens d'exploration pour l'exploration du signal analogique pour la génération d'une séquence de valeurs d'exploration i(n) numérisées, en particulier discrètes en temps et en amplitude, avec i = 0, ..., n, exactement une valeur d'exploration i(n) étant générée par période (PD) de la modulation des impulsions en largeur et l'exploration du signal analogique pour la génération de la séquence de valeurs d'exploration i(n) numérisées étant mise en oeuvre en milieu de période,
   - des moyens de génération de valeur moyenne pour la formation d'une valeur moyenne de signal i_mittel(n-1) du signal analogique sur la période ayant précédé la valeur d'exploration i(n) actuelle, en représentation numérique, grâce à l'exploration du signal analogique pour la génération d'une pluralité M de valeurs d'exploration intermédiaires z(1) à z(M) numérisées, en particulier discrètes en temps et en amplitude, pour la période précédente, et la formation d'une valeur moyenne des valeurs d'exploration intermédiaires à partir des valeurs d'exploration intermédiaires générées en tant que valeur moyenne de signal, et
   - des moyens de calcul pour le calcul d'une valeur de mesure actuelle mw à l'aide de l'équation mw = i(n) - i(n-1) + i_mittel(n-1).

# Fig.1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102007032484 A1
- EP 0454946 A1
- EP 1333291 A1
- WO 03032689 A1